# EUROPEAN PATENT APPLICATION

(11) **EP 4 082 955 A1**
(43) Date of publication of application: **02.11.2022**
(21) Application number: 20904799.2
(22) Date of filing: 04.11.2020
(51) Int. Cl.: B66B 3/00, G06Q 10/04

(54) **ARCHITECTURAL MODEL DATA ASSISTANCE SYSTEM AND ARCHITECTURAL MODEL DATA ASSISTANCE METHOD**

(30) Priority: 26.12.2019 JP 2019235688
(71) Applicant: Hitachi, Ltd., Tokyo 100-8280 (JP)
(72) Inventor: FUJIWARA Masayasu, Tokyo 100-8280 (JP); HATORI Takahiro, Tokyo 101-8941 (JP); TORIUMI Wataru, Tokyo 100-8280 (JP)
(74) Representative: MERH-IP Matias Erny Reichl Hoffmann Patentanwälte PartG mbB
(86) International application number: PCT/JP2020/041160
(87) International publication number: WO 2021/131332

(57) **Abstract**

To enable a simulation that takes into consideration the detailed movements and determinations of people at an elevator platform without manually providing data about front-of-line position information, the present invention: includes a front-of-line position estimation unit that estimates a front-of-line position of people at an elevator platform; estimates, from inputted architectural model data, the front-of-line position at the elevator platform; and simulates overall movement in a building, including an action of waiting at the platform and an action of orderly boarding when using the elevator, using the estimated front-of-line position and the architectural model data as inputs.

## Description

### Technical Field

The present invention relates to an architectural model data assistance system and an architectural model data assistance method.

### Background Art

In planning and construction of high-rise buildings, information sharing among parties has been promoted by utilizing architectural model data called building information modeling (BIM) data or the like. The architectural model data is data including a plurality of architectural model parts, and the architectural model parts are data indicating building materials constituting a high-rise building, facilities such as elevators, and the like.

The information constituting the architectural model parts includes at least 2D or 3D shape data, and may further include any accompanying information such as specifications, model numbers, and manufacturers. The architectural model data also includes general BIM data.

Patent Literature 1 discloses a method and a device for performing evaluation using a simulation technique using architectural model data incorporating architectural model parts of an elevator as an input.

In addition, Patent Literature 2 discloses a device that reproduces detailed movements, determinations, and the like of a user at an elevator platform by a technique for simulating use of the elevator.

### Citation List

### Patent Literature

Patent Literature 1: JP 2014-10659 A
Patent Literature 2: WO 2017/199532 A

### Summary of Invention

### Technical Problem

However, in the method of simulating a motion of a person using the system disclosed in Patent Literature 1, an action of waiting at a platform or an action of orderly boarding when a large number of people use an elevator is not considered.

In Patent Literature 2, in order to reproduce the orderly boarding action at the elevator, it is necessary to input data of the front-of-line position at the elevator platform.

That is, in the techniques described in Patent Literature 1 and Patent Literature 2, in an architectural model to which architectural model data is input, it is not considered to finely simulate the action of waiting at the platform or the action of orderly boarding when using the elevator without manually additionally inputting the front-of-line position or the like.

Therefore, an object of the present invention is to provide an architectural model data assistance system and an architectural model data assistance method capable of finely simulating an action of waiting at a platform or an action of orderly boarding by an elevator user without manually additionally inputting the front-of-line position or the like.

### Solution to Problem

In order to solve the above problem, for example, the configuration described in the claims is adopted.

The present application includes a plurality of means for solving the above problem, and as an example thereof, the present invention includes a storage unit that stores architectural model data and simulation data, an architectural model data reading unit that reads the architectural model data stored in the storage unit, and a front-of-line position estimation unit that estimates a front position of a line of people who use the elevator on the basis of the architectural model data read by the architectural model data reading unit.

### Advantageous Effects of Invention

According to the present invention, it is possible to realize a simulation in consideration of detailed movements of people at an elevator platform without manual data editing.

Problems, configurations, and effects other than those described above will be clarified by the description of embodiments described below.

### Brief Description of Drawings

Fig. 1 is a system block diagram illustrating a functional configuration of a first embodiment example of an architectural model data assistance system of the present invention.
Fig. 2 is a diagram illustrating a hardware configuration of a device of the first embodiment example of the architectural model data assistance system of the present invention.
Fig. 3 is a flowchart of front-of-line position estimation processing of the first embodiment example of the architectural model data assistance system of the present invention.
Fig. 4 is a diagram illustrating a process of estimation processing in a case where the arrangement of elevators at a platform is face-to-face arrangement in the front-of-line position estimation processing of the first embodiment example of the architectural model data assistance system of the present invention.
Fig. 5 is a diagram illustrating a process of estimation processing in a case where the arrangement of elevators at a platform is linear line arrangement in the front-of-line position estimation processing of the first embodiment example of the architectural model data assistance system of the present invention.
Fig. 6 is a diagram illustrating a process of estimation processing in a case where the arrangement of elevators at a platform is linear line arrangement and the doorway of the platform faces the doors of the elevators in the front-of-line position estimation processing of the first embodiment example of the architectural model data assistance system of the present invention.
Fig. 7 is a system block diagram illustrating a functional configuration of a second embodiment example of an architectural model data assistance system of the present invention.
Fig. 8 is a flowchart of front-of-line position estimation processing of the second embodiment example of the architectural model data assistance system of the present invention.
Fig. 9 is a diagram illustrating an example of measurement information of a measurement unit of the second embodiment example of the architectural model data assistance system of the present invention.
Fig. 10 is a diagram illustrating an example of a process of front-of-line position estimation processing using the measurement unit of the second embodiment example of the architectural model data assistance system of the present invention.
Fig. 11 is a diagram illustrating an example of data of an elevator platform extracted from architectural model data in the architectural model data assistance system of the present invention.
Fig. 12 is a flowchart illustrating processing of estimating the front-of-line position using a sensor in the architectural model data assistance system of the present invention.

### Description of Embodiments

### <Description of the first embodiment example>

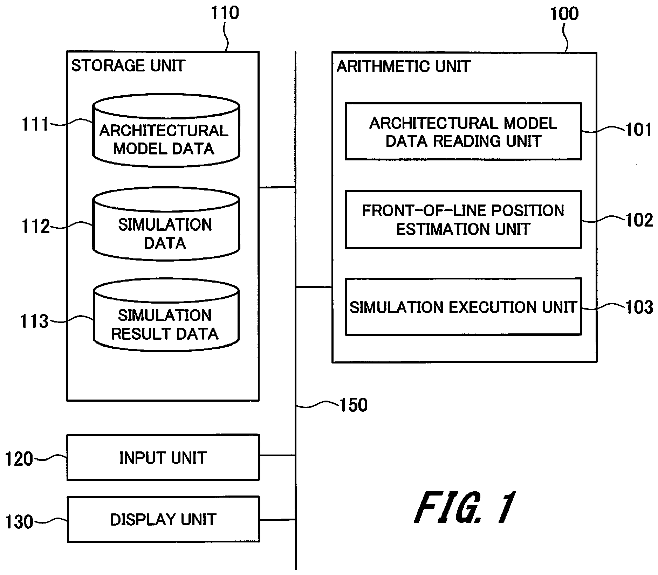

Hereinafter, an architectural model data assistance system of the first embodiment example of the present invention (hereinafter, referred to as "the present example") will be described with reference to Figs. 1 to 6.

### [Functional configuration of the architectural model data assistance system of the present example]

Fig. 1 is a diagram illustrating a configuration of the architectural model data assistance system of the present example. An overall configuration of the architectural model data assistance system of the present example will be described with reference to Fig. 1.

The architectural model data assistance system of the present example includes an arithmetic unit 100, a storage unit 110, an input unit 120, and a display unit 130 connected by a bus 150.

Note that each unit of the architectural model data assistance system may be connected by a network instead of being connected by the bus 150. The input unit 120 and the display unit 130 are additional configurations, and are not necessarily required for the architectural model data assistance system of the present example.

The storage unit 110 has a storage area for storing at least architectural model data 111 and simulation data 112, but may further have a storage area for storing simulation result data 113.

The arithmetic unit 100 includes at least an architectural model data reading unit 101, a front-of-line position estimation unit 102, and a simulation execution unit 103.

Note that the arithmetic unit 100 may be configured as a single arithmetic unit, but the arithmetic unit 100 may be configured to be distributed into a plurality of parts such that a part of the arithmetic unit 100 is provided in a server, which is not illustrated.

The configuration of the architectural model data assistance system of the present example has been described above.

### [Function of each configuration in the architectural model data assistance system of the present example]

The architectural model data reading unit 101 of the arithmetic unit 100 reads the architectural model data 111 from the storage unit 110. The architectural model data reading unit 101 recognizes the shape of the architectural model data on the basis of the read architectural model data 111, and converts the architectural model data into data of a format that can be executed by the simulation execution unit 103.

Here, converting into data of an executable format means converting the architectural model data 111 into, for example, elevator platform data. That is, in the conversion into the data of an executable format, the architectural model data reading unit 101 extracts the elevator platform data from the architectural model data 111. Then, the architectural model data reading unit 101 inputs the extracted elevator platform data to the front-of-line position estimation unit 102.

Note that, as the processing of extracting the elevator platform data, a method of cutting out a space within a certain distance from the door of an elevator as a platform is conceivable.

The front-of-line position estimation unit 102 estimates the front-of-line position on the basis of the input elevator platform data. The front-of-line position information estimated by the front-of-line position estimation unit 102 is input to the simulation execution unit 103. At this time, data obtained by converting the architectural model data 111 read by the architectural model data reading unit 101 into a simulation executable format is also input to the simulation execution unit 103.

The simulation execution unit 103 estimates detailed movements of people at the elevator platform and stores the simulation result in the simulation result data 113 of the storage unit 110. Note that the simulation result may be directly output and displayed on the display unit 130 without being stored in the storage unit 110.

Note that the simulation in the simulation execution unit 103 can be performed, for example, by using a known simulation technique disclosed in "Development of pedestrian flow simulator for smooth people movement in buildings" (FUJIWARA Masayasu, TORIYABE Satoru, and HATORI Takahiro) presented by the inventors in "The Proceedings of the Elevator, Escalator and Amusement Rides Conference" of The Japan Society of Mechanical Engineers held on January 19, 2018.

### [Hardware configuration of the architectural model data assistance system of the present example]

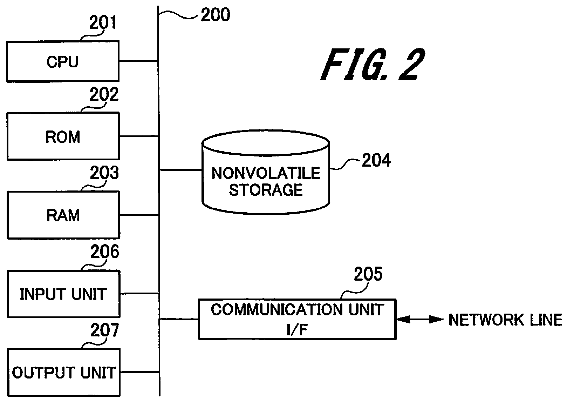

Fig. 2 is a diagram illustrating a hardware configuration of the architectural model data assistance system of the present example illustrated in Fig. 1.

As illustrated in Fig. 2, the architectural model data assistance system of the present example includes a central processing unit (CPU) 201, read only memory (ROM) 202, random access memory (RAM) 203, and a nonvolatile storage 204 connected to a bus 200. In addition, a communication interface (communication unit IF) 205 for communicating with the outside is provided.

The CPU 201 reads, from the ROM 202, a program code of software for implementing the function of each unit of the architectural model data assistance system of the present example, and executes the program code. Variables and the like generated in the middle of arithmetic processing performed in the architectural model data assistance system of the present example are temporarily written in the RAM 203. The CPU 201 executes the program code recorded in the ROM 202, thereby implementing various functions of the architectural model data assistance system of the present example described above.

As the communication interface 205, for example, a network interface card (NIC) or the like is used. Although not illustrated in Fig. 1, the communication interface 205 is used for communication with an external apparatus as necessary.

The nonvolatile storage 204 includes nonvolatile memory such as a solid state drive (SSD), and stores and holds programs, data, and the like necessary for the operation of the CPU 201. In addition, the nonvolatile storage 204 constitutes the storage unit 110 in Fig. 1. In addition, although an input unit 206 and an output unit 207 are provided in Fig. 2, the input unit 206 and the output unit 207 are not necessarily essential for the hardware configuration of the architectural model data assistance system of the present example. Here, the output unit 207 includes the display unit 130 in Fig. 1.

### [Flow of processing of the architectural model data assistance system of the present example]

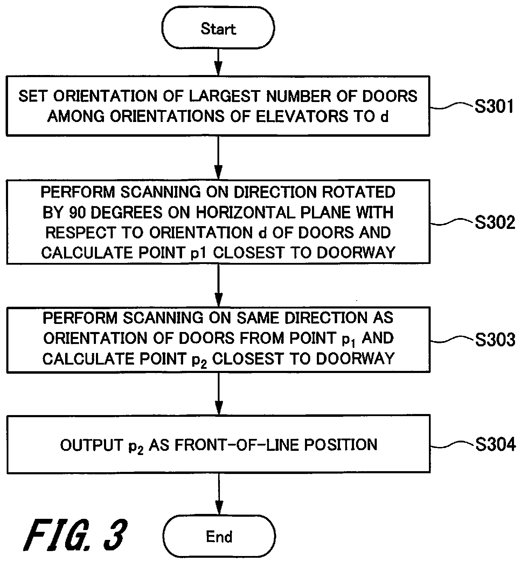

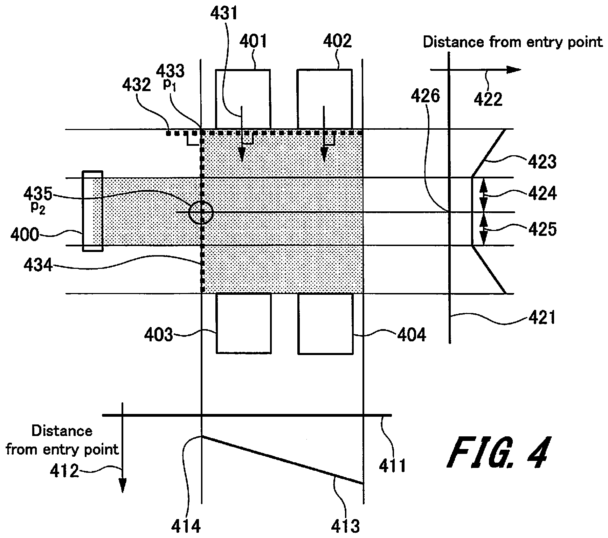

Next, with reference to the flowchart of Fig. 3 and the drawings of specific cases illustrated in Figs. 4 to 6, the front-of-line position estimation processing of the front-of-line position estimation unit 102 of the architectural model data assistance system of the present example will be described.

First, an orientation "d" of the largest number of doors is selected among the orientations of the doors of elevators (step S301). For example, in the case of a general face-to-face arrangement in which six elevators are arranged to face each other, the orientations of the doors of the three elevators face the three elevators. In such a case, since the number of elevators facing each other is "3", which is the maximum, one of the orientations in which the number is the maximum is selected and set to "d".

To describe by using the specific example of Fig. 4, Fig. 4 illustrates an elevator platform having a face-to-face arrangement in which four elevators are arranged so that two elevators face the two elevators. In step S301, the orientation "d" of the door is acquired from each elevator, and in Fig. 4, there are doors installed in the same direction for two elevators of elevators 401 and 402 and two elevators of elevators 403 and 404. Since the number of doors in a direction 431 is the same and is the maximum, the direction of the orientation 431 of the doors of the elevators 401 and 402 is set to "d". Even when the orientation of the doors of the elevators 403 and 404 is set to "d", the subsequent processing can be similarly performed.

Next, scanning is performed with a direction rotated by 90 degrees and a direction rotated by -90 degrees with respect to the direction "d" of the orientation 431 of the doors of the elevators as the scanning direction. Then, a position where the distance to a doorway 400 is minimum is scanned regarding the direction rotated by 90 degrees from the direction "d" of the doors. In Fig. 4, this scanning position is indicated by a dotted line 432. Then, next, the distance to the doorway 400 is obtained at each position of a scanning target, and a point 433 closest to the doorway 400 is calculated as "p1" (step S302). In Fig. 4, the distance between the scanning position and the doorway 400 is illustrated as a solid line graph 413. A horizontal axis 411 indicates the scanning position, and a vertical axis 412 indicates the distance from the doorway.

As is clear from the graph 413, it is indicated that the point 433 at the end on the doorway 400 side is closest to the doorway. That is, the position 433 at the end on the doorway 400 side among the scanning positions indicated by the dotted line 432 is "p1".

Next, scanning is performed along a dotted line 434 in the same direction as the direction 431 "d" of the doors from the position "p1" of the point 433, a point closest to the doorway 400 is calculated, and this point 435 is set as "p2" (step S303). Then, the distance to the doorway 400 is obtained at each position of the dotted line 434. The distance between each position of the dotted line 434 and the doorway 400 is indicated by a graph 423. In the graph 423, a vertical axis 421 indicates the scanning position, and a horizontal axis 422 indicates the distance from the doorway 400.

In the graph 423, a portion where the distance from the doorway 400 is minimum is indicated by a range 424 and a range 425, and cannot be uniquely specified. Therefore, the scanning position 435 corresponding to a barycentric position 426 of the plurality of positions where the distance from the doorway 400 is minimum is set as the point "p2" closest to the doorway 400.

Then, the position "p2" of the scanning position 435, which is the point closest to the doorway 400, is output as the front-of-line position (step S304). The front-of-line position estimation processing process using Figs. 3 and 4 is as described above.

Here, as illustrated in Fig. 4, scanning can be easily performed by determining points to be scanned discretely at regular intervals and searching the doorway 400 from the determined points. The distance from an arbitrary point of the scanning position to the doorway 400 is measured by discretizing the space. The scanning range may be arbitrarily limited. As an example of the limitation of the scanning range, it is conceivable to limit the range such that the distance to the nearest elevator does not exceed the upper limit.

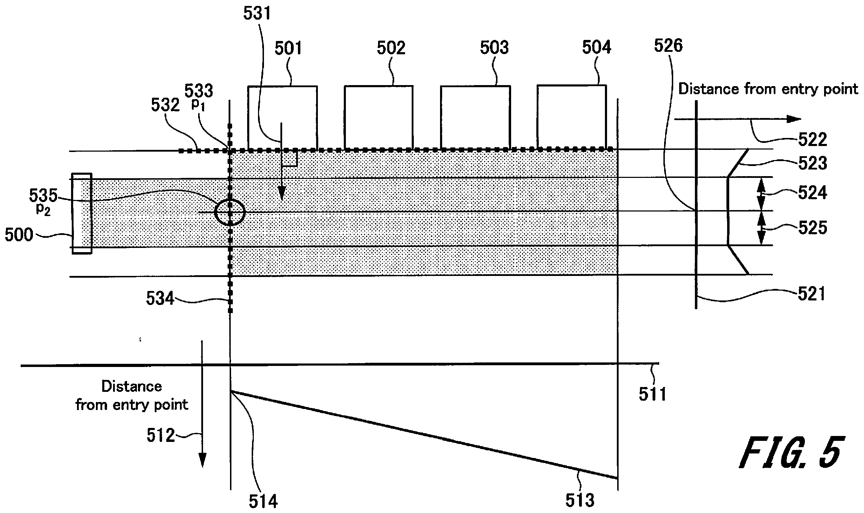

Fig. 5 is a specific example of an elevator arrangement different from Fig. 4, and illustrates elevator platform data of a planar arrangement in which four elevators are arranged in a line. The process of estimating the front-of-line position will be described below with reference to Fig. 5.

First, in step S301 of Fig. 3, "d", which is the direction 531 of the door, is acquired from each elevator. In this example, the doors of four elevators 501, 502, 503, and 504 face in the same direction 531. Therefore, this direction 531 is the orientation of the largest number "four" elevators, and this direction is "d".

Then, in step S302 of Fig. 3, a position where the distance to a doorway 500 is minimum is scanned in the direction rotated by 90 degrees from the direction 531 "d" of the doors. In Fig. 5, scanning is performed along a dotted line 532, and the distance to the doorway 500 is obtained at each position of the scanning target. The distance between each scanning position and the doorway 500 is indicated by a graph 513. In the graph 513, a horizontal axis 511 indicates the scanning position, and a vertical axis 512 indicates the distance from the doorway.

It can be seen from the graph 513 of Fig. 5 that an end 514 on the doorway side is closest to the doorway 500. Thus, a scanning position 533 corresponding to the end 514 on the doorway side is set as "p1".

Next, in step S303 of Fig. 3, a point closest to the doorway 500 is scanned from the position 533 "p1" at the end on the doorway 500 side in the same direction as the direction 531 "d" of the doors. A scanning position is indicated by a dotted line 534. Then, the distance to the doorway 500 is obtained at each position of the scanning target. A relationship of the distance between each scanning position and the doorway 500 is indicated by a graph 523. In the graph 523, a vertical axis 521 indicates the scanning position, and a horizontal axis 522 indicates the distance from the doorway.

As can be seen from the graph 523, a portion where the distance from the doorway 500 is minimum is a range 524 and a range 525, and cannot be uniquely specified. Therefore, a scanning position 535 that is close to the doorway 500 and corresponds to a barycentric position 526 of the plurality of positions where the distance from the doorway 500 is minimum is set as "p2".

Then, in step S304 of Fig. 3, the point "p2" of the scanning position 535 close to the doorway 500 is output as the front-of-line position. This is the end of the description of the front-of-line position estimation processing process using Fig. 5.

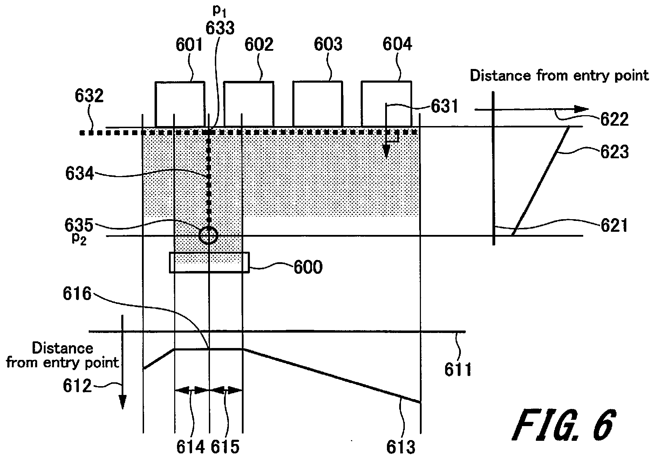

Similarly to Fig. 5, Fig. 6 is a planar arrangement in which four elevators are arranged in a line, but illustrates an elevator platform in which a doorway 600 faces a direction 631 of the doors of the elevators. The process of estimating the front-of-line position will be described below with reference to Fig. 6.

First, in step S301 of Fig. 3, the direction "d" of the door of each elevator is acquired. In this example, the doors of four elevators 601, 602, 603, and 604 are arranged to face in the same direction 631. Therefore, this same direction 631 is the orientation of the largest number "four" elevators, and this direction 631 of the doors is "d".

Next, in step S302 of Fig. 3, a position where the distance to the doorway 600 is minimum is scanned along a dotted line 632 in the direction rotated by 90 degrees from the direction 631 "d" of the doors. Then, the distance to the doorway 600 is obtained from each scanning position on the dotted line 632. The distance between each scanning position and the doorway 600 is indicated by a graph 613. In the graph 613, a horizontal axis 611 indicates the scanning position and a vertical axis 612 indicates the distance from the doorway 600.

As can be seen from the graph 613, a portion where the distance from the doorway 600 is minimum is a range 614 and a range 615, and cannot be uniquely specified. Thus, a scanning position 633 corresponding to a position 616, which is the barycenter of the ranges 614 and 615 where the distance from the doorway 600 is minimum, is set as point "p1".

Then, in step S303 of Fig. 3, scanning is performed along a dotted line 634 from the point "p1" of the scanning position 633 to the doorway 600, and the distance between the position of the scanning target and the doorway 600 is obtained. Then, an end 635 of the scanning position closest to the doorway 600 is set as point "p2". A graph 623 indicates the distance between the scanning position and the doorway 600. In the graph 623, a vertical axis 621 indicates the scanning position, and a horizontal axis 622 indicates the distance from the doorway 600.

As can be seen from Fig. 6, from the graph 623, the distance between the position of the end 635 on the doorway 600 side of the dotted line 634, which is the scanning position, and the doorway 600 is minimum. Thus, the position of the end 635 on the doorway 600 side is set as point "p2".

Then, in step S304 of Fig. 3, the point "p2" of the end 635 on the doorway 600 side is output as the front-of-line position. This is the end of the description of the front-of-line position estimation processing process using Fig. 6.

### <Description of the overall configuration of the second embodiment example of the present invention>

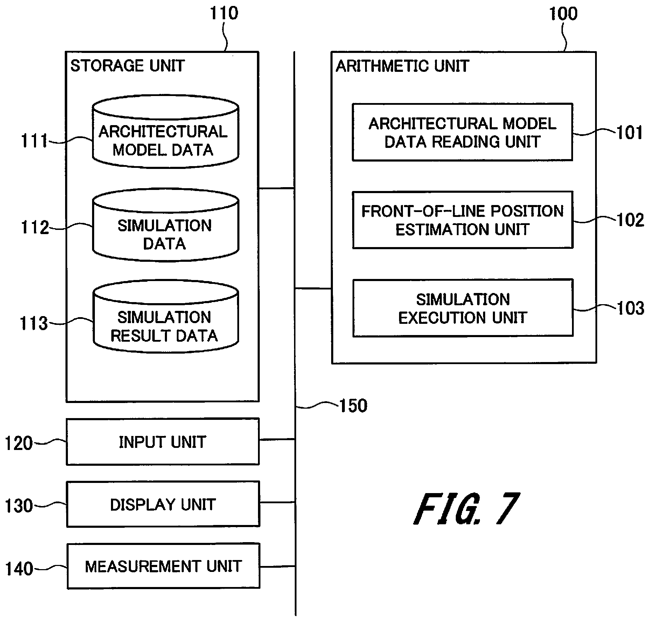

Next, an architectural model data assistance system of the second embodiment example of the present invention will be described with reference to Figs. 7 to 12.

Fig. 7 illustrates a functional device configuration of an architectural model data assistance system of the second embodiment example of the present invention. Note that since the hardware configuration is the same as that of the first embodiment example illustrated in Fig. 2, the description thereof will be omitted. The second embodiment example of the present invention is different from the first embodiment example illustrated in Fig. 1 in that a measurement unit 140 is provided.

That is, the second embodiment example of the present invention is an embodiment example in which measurement data measured by the measurement unit 140 is used as an input of the front-of-line position estimation processing. Hereinafter, differences from the first embodiment example will be mainly described with reference to Figs. 7 to 10.

Referring to Fig. 7, the architectural model data assistance system of the second embodiment example of the present invention includes an arithmetic unit 100, a storage unit 110, and the measurement unit 140. The measurement unit 140 is connected to a bus 150 directly or via a network. Note that, as in the first embodiment example, an input unit 120 and a display unit 130 are not necessarily required configurations, but may be provided.

Similarly to the first embodiment example illustrated in Fig. 1, at least architectural model data 111 and simulation data 112 are stored in the storage unit 110. In addition, simulation result data 113 is also stored as necessary.

In addition, as in the first embodiment example, the arithmetic unit 100 includes an architectural model data reading unit 101, a front-of-line position estimation unit 102, and a simulation execution unit 103. The arithmetic unit 100 may be configured as a single arithmetic unit or may be configured to be distributed into a plurality of parts.

Note that an image sensor such as a camera, a depth sensor, an infrared sensor, or the like is used as the measurement unit 140.

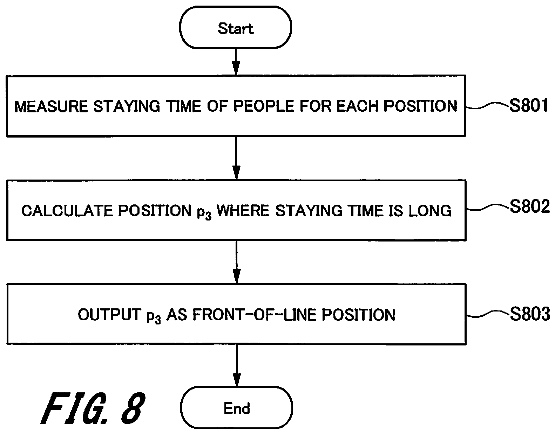

Fig. 8 is a flowchart illustrating a flow of processing of the front-of-line position estimation unit 102 in the architectural model data assistance system of to the second embodiment example.

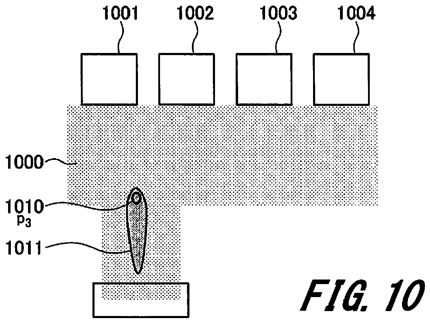

First, the measurement unit 140 such as a camera or the like measures the staying time of people including an elevator user for each position of the elevator platform (step S801). Then, a position "p3" where the staying time of the people is long is calculated (step S802). Here, the position "p3" where the staying time is long refers to a place where the density of people is high at the elevator platform, and, for example, a space indicated by numeral 1010 in Fig. 10 corresponds thereto. Then, the front-of-line position estimation unit 102 outputs the position "p3" where the staying time is long as the front-of-line position (step S803).

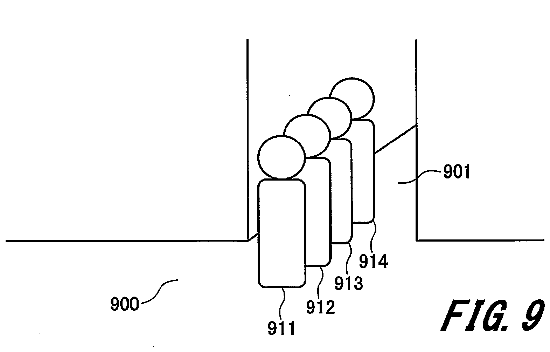

Fig. 9 illustrates an example of image data of a measurement result measured by the measurement unit 140 such as a camera or the like installed at the elevator platform. This image data indicates an example of image data measured in a case where the measurement unit 140 such as a camera or the like is installed above an elevator platform 900 to face an entrance 901 of the elevator platform. This image data illustrates a situation in which four people of elevator users 911, 912, 913, and 914 are lined up at the entrance of the elevator platform and wait for the arrival of the elevator.

Next, Fig. 10 is a plan view of an elevator platform 1000 including four elevators 1001, 1002, 1003, and 1004. That is, Fig. 10 is a diagram illustrating the density of people on a plan view of the elevator platform 1000 from image data of a plurality of persons continuously measured by the measurement unit 140 such as a camera or the like.

In addition, Fig. 10 illustrates the magnitude of the density of people, numeral 1011 denotes a space having a relatively low density, and numeral 1010 denotes a space having a relatively high density. The space of numeral 1010 illustrated as the space having a high people density is a space equal to or larger than a predetermined threshold. As already described with reference to Fig. 8 as the second embodiment example, the position of the space having a high people density indicated by numeral 1010 is the front-of-line position "p3". That is, in the second embodiment example, the position close to the elevator in the space having a high people density is estimated as the front-of-line position "p3".

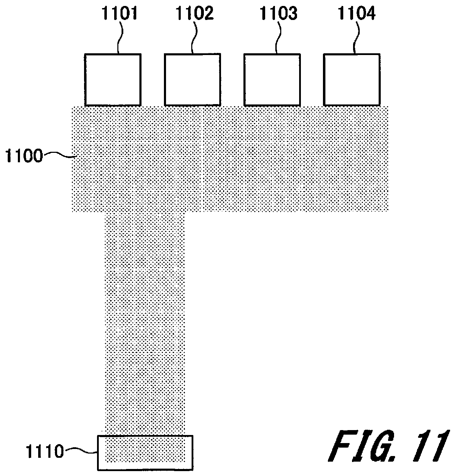

Fig. 11 illustrates an example of elevator platform data extracted from the architectural model data 111 stored in the storage unit 110.

Here, the architectural model data 111 and elevator platform data included in the architectural model data 111 will be described. The architectural model data 111 includes elevator platform data. Here, the elevator platform data includes at least information regarding a floor 1100 of the elevator platform, information regarding elevators 1101, 1102, 1103, and 1104, and information of a doorway or a position 1110 connected to the doorway.

The information regarding the floor 1100 and the information regarding the elevators 1101, 1102, 1103, and 1104 have positions and shapes, and Fig. 11 illustrates these pieces of information as a plan view.

The doorway of the architectural model data assistance system of the present invention includes not only a doorway of a building but also a doorway to a space owned by a tenant such as an office on each floor. The information of the doorway is included in the architectural model data 111. Then, the flow of people in the building may be estimated by recognizing a door or a tenant area included in the architectural model data 111, or may be designated manually. From this floor information, it is possible to recognize a passable space of the elevator platform.

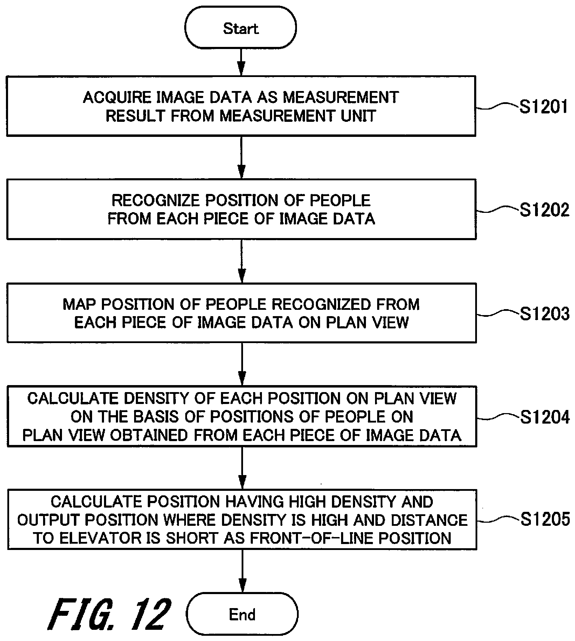

Fig. 12 is a flowchart for describing processing of estimating the front-of-line position using a plurality of pieces of image data obtained by the measurement unit 140 such as a camera or the like illustrated in Fig. 7 as an input.

First, the measurement unit 140 acquires the image data measured by the camera or the like as a measurement result (step S1201).

Then, the measurement unit 140 recognizes the position of people from each piece of image data acquired in step S1201 (step S1202). Here, in order to recognize the position of people from the image data, a widely known general image recognition method or a method such as machine learning is used.

Next, the position of people recognized from each piece of the image data is mapped on a plan view (step S1203). In order to perform mapping on the plan view, it is necessary to convert the position of people in the coordinate system of the image data into the coordinate system on the plan view.

Therefore, first, the distance to the position of the people recognized from the installation position of the measurement unit 140 is estimated according to the magnitude of the size of people recognized in the image. Then, conversion to the coordinate system on the plan view is performed using the estimated distance information, the position of the coordinate system of the image data, the coordinates and orientation of the installation position of the measurement unit 140, and the information of the angle of view of the measurement unit 140. Note that the coordinate system conversion method is not limited to the method described here. Other methods can also be used.

Next, the density of each position on the plan view is calculated on the basis of the positions of people on the plan view obtained from each piece of the image data (step S1204). The density of people on a plane refers to a value obtained by calculating a ratio of the number of pieces of data of existing people to the number of pieces of measured image data for each position to be measured. The result of calculating the density of people in step S1204 has already been described with reference to Fig. 10, and the position for which the density is calculated can also be evaluated by a grid discretized at an arbitrary interval.

Finally, the position having a high people density is calculated, and the position where the density is high and the distance to the elevator is short is output as the front-of-line position (step S1205). It is sufficient if the position having a high people density is determined on the basis of whether a preset threshold is exceeded. Note that a preset value may be used as the threshold, or the threshold may be dynamically changed according to the date and time or the time zone. In addition, the threshold can be changed depending on a position or a place. For example, it is also conceivable to change the threshold depending on the distance from a wall.

In addition, since it is not particularly necessary for the elevator users to line up during the time when the elevator platform is not crowded, it is not necessary to measure the front-of-line position. Therefore, the front-of-line position may be calculated only from a measurement result with a limited time zone such as the time zone at the time of going to work or leaving work and the time zone at lunch time. In addition, a certain threshold may be set for the density of people, and the front-of-line position may be estimated with respect to the measurement result for the time zone in which the density exceeds the threshold.

The front-of-line position estimation processing has been described above.

As described above, according to the present invention, in the architectural model data assistance system, it is possible to realize the architectural model data assistance system that estimates the front-of-line position by the measurement unit 140, uses the estimated front-of-line position and the architectural model data as inputs, and finely simulates the action of waiting at the platform or the action of orderly boarding when using the elevator in the input architectural model.

In addition, according to the present invention, in the architectural model data assistance system, it is possible to realize the architectural model data assistance system that uses the architectural model data as an input and finely simulates the action of waiting at the platform or the action of orderly boarding when using the elevator in the input architectural model without manually additionally inputting the front-of-line position or the like.

Note that the present invention is not limited to the above-described embodiments, and includes various modifications. The above-described embodiments have been described in order to describe the present invention in an easy-to-understand manner, and the present invention is not necessarily limited to those including all the described configurations, and can be appropriately applied to other configurations.

In addition, some or all of the above-described configurations, functions, processing units, processing means, and the like may be realized by hardware, for example, by designing with an integrated circuit. In addition, each of the above-described configurations, functions, and the like may be realized by software by a processor interpreting and executing a program for realizing each function. Information such as a program, a table, and a file, and the like for realizing each function can be stored in a recording device such as memory, a hard disk, and a solid state drive (SSD), or a recording medium such as an IC card, an SD card, and a DVD, and the like.

In addition, in the drawings, control lines and information lines considered to be necessary for description are illustrated, and not all control lines and information lines of a product are necessarily illustrated. In practice, it may be considered that almost all the configurations are connected to each other.

### Reference Signs List

- 100: Arithmetic unit
- 101: Architectural model data read unit
- 102: Front-of-line position estimation unit
- 103: Simulation execution unit
- 110: Storage unit
- 111: Architectural model data
- 112: Simulation data
- 113: Simulation result data
- 120: Input unit
- 130: Display unit
- 140: Measurement unit

## Claims

1. An architectural model data assistance system comprising:
a storage unit that stores architectural model data and simulation data;
an architectural model data reading unit that reads the architectural model data stored in the storage unit; and
a front-of-line position estimation unit that estimates a front position of a line of people who use elevators at an elevator platform on a basis of the architectural model data read by the architectural model data reading unit.

2. The architectural model data assistance system according to claim 1, wherein
the front-of-line position estimation unit estimates the front position of the line of people who use the elevators on a basis of a shape of the elevator platform and a positional relationship of the elevators.

3. The architectural model data assistance system according to claim 1, further comprising:
a measurement unit that measures a situation of the elevator platform in the elevator platform, wherein
the front-of-line position estimation unit estimates the front position of the line of people who use the elevators on a basis of elevator platform data obtained by measurement by the measurement unit.

4. The architectural model data assistance system according to claim 3, wherein
the measurement unit calculates a density of people at each point of the elevator platform on a basis of measured data, and sets a point where the density exceeds a preset predetermined threshold as a front-of-line position.

5. The architectural model data assistance system according to claim 4, wherein
the predetermined threshold is variably set depending on a time zone or a front-of-line position.

6. The architectural model data assistance system according to any one of claims 3 to 5, wherein the measurement unit includes any one or a plurality of an image sensor, a depth sensor, and an infrared sensor.

7. The architectural model data assistance system according to any one of claims 1 to 3, further comprising:
a simulation execution unit, wherein
the simulation execution unit simulates an action of a user who uses an elevator to wait at an elevator platform or an action of orderly boarding.

8. An architectural model data assistance method comprising:
a step of determining an orientation "d" of doors of elevators on a side where a number is largest among orientations of the elevators;
a step of scanning a direction rotated by 90° on a horizontal plane with respect to the orientation "d" of the doors, and calculating a first point "p1" closest to a doorway on a line in the direction rotated by 90°;
a step of scanning from the point "p1" closest to the doorway in a direction of the orientation of the doors and calculating a second point "p2" closest to the doorway; and
a step of outputting the point "p2" as a front-of-line position.
